Europäisches Patentamt

European Patent Office

Office européen des brevets

(11) Veröffentlichungsnummer: **0 105 832**
**B1**

(12) **EUROPÄISCHE PATENTSCHRIFT**

(45) Veröffentlichungstag der Patentschrift:
**27.11.85**

(21) Anmeldenummer: **83730090.4**

(22) Anmeldetag: **27.09.83**

(51) Int. Cl.⁴: **B 23 K 1/08**, B 23 K 3/06,
H 05 K 3/34

(54) Schwallötgerät.

(30) Priorität: **30.09.82 DE 3236493**

(43) Veröffentlichungstag der Anmeldung:
**18.04.84 Patentblatt 84/16**

(45) Bekanntmachung des Hinweises auf die Patenterteilung:
**27.11.85 Patentblatt 85/48**

(84) Benannte Vertragsstaaten:
**AT BE CH DE FR GB IT LI LU NL SE**

(56) Entgegenhaltungen:
**DE - B - 1 527 412**
**DE - C - 1 527 294**

(73) Patentinhaber: **ERSA Ernst Sachs KG GmbH & Co.,
Leonhard-Karl-Strasse 24, D-6980 Wertheim / Main (DE)**

(72) Erfinder: **Shtalryd, Haim, Branitzki 31,
Rishon-Lezion 75 239 (IL)**

(74) Vertreter: **Lüke, Dierck-Wilm, Dipl.-Ing.,
Gelfertstrasse 56, D-1000 Berlin 33 (DE)**

## Beschreibung

Die Erfindung bezieht sich auf ein Schwallötgerät gemäss der Gattung des Patentanspruches 1.

Bei einem aus der DE 15 27 294 vorbekannten gattungsgemässen Schwallötgerät ist der Lötbadbehälter durch eine horizontale Zwischenwand in eine unterhalb derselben liegende Druckkammer und eine darüber liegende Rücklaufkammer für das flüssige Lot unterteilt. Die horizontale Zwischenwand ist mit einem Schlitz für die darauf sitzende Schwallotdüse versehen. Seitlich davon befindet sich in einem Abstand ein Durchbruch für die Druckerzeugungseinrichtung in Form eines motorisch angetriebenen Leitrades, das mit zur Zwischenwand senkrechter Achse angeordnet ist. Eine solche, durch das Leitrad gebildete Umwälzpumpe für das flüssige Lot erzeugt eine starke Strömung des flüssigen Lotes, so dass auch der oberhalb aus der Schwallötdüse austretende Schwall unruhig und daher nicht konstant ist. Auch werden durch die Strömung innerhalb der Druckkammer abgelagerte Lötmittelreste ständig mitgerissen und dem aus der Düse austretenden Lotschwall zugeführt, wodurch es zu unsauberen Lötstellen kommt. Ferner ist für eine Pumpe in Form des Leitrades, der notwendigerweise gelagerten Antriebsachse und des notwendigen Antriebsmotors ein grosser Platzbedarf für Motor und Leitrad erforderlich. Die Welle muss im Lotbadgehäuse gelagert werden, wodurch ein Verschleiss bewegter Teile eintritt, der einen regelmässigen Wartungsdienst erforderlich macht. Auch ist ein relativ grosses Lötzinnvolumen notwendig. Damit ist eine hohe Aufheizzeit erforderlich. Grosses Lötzinnvolumen und lange Aufheizzeit erfordern einen grossen Energieaufwand, der wiederum zusätzlich zu den hohen Materialkosten zusätzliche Kosten schafft.

Der Erfindung liegt von daher die Aufgabe zugrunde, ein Schwallötgerät der gattungsgemässen Art dahingehend auszubilden, dass bei geringem Bauaufwand, insbesondere geringem Bauvolumen und geringen Betriebskosten ein ruhiger und gleichmässiger Lotschwall konstanter Grösse am Austritt der Schwallerzeugungsdüse erzeugt werden kann und dass eine Rückführung des aus der Schwallerzeugungsdüse ausgetretenen flüssigen Lotes in den Druckraum in einfacher Weise möglich ist.

Die Lösung dieser Aufgabe ergibt sich aus den kennzeichnenden Merkmalen des Patentanspruches 1. Das innerhalb der Druckkammer gebildete Druckluftpolster erzeugt einen aus der Schwallötdüse austretenden, ruhigen und gleichmässigen Lotschwall konstanter Grösse. Es steht somit eine ruhige Lötwelle sowohl zum Löten als auch zum Entlöten von elektronischen Bauteilen an Leiterplatten zur Verfügung. Da kein eine unruhige Strömung erzeugendes Leitrad innerhalb der Druckkammer vorhanden ist, tritt auch keine starke Bewegung des flüssigen Lotes auf. Da weder Antriebsmotor noch Leitrad für die Erzeugung einer Strömung des flüssigen Lotes notwendig sind, ist auch ein kleines Bauvolumen möglich, so dass das Schwallötgerät einfach herstellbar und mit geringen Betriebskosten und servicefreundlich betreibbar ist.

Die Erzeugung einer ständigen Lötwelle wird dadurch ermöglicht, dass das aus der Düse austretende flüssige Lot über die Rücklaufkammer und die mit dem Rückschlagventil versehene Rücklaufleitung wieder in die Druckkammer zurückgeführt werden kann, und zwar dann, wenn das Druckluftpolster innerhalb der Druckkammer entlüftet wird. In diesem Falle läuft das schmelzflüssige Lot selbsttätig über die Rücklaufleitung aus der Rücklaufkammer zurück in die Druckkammer. Beim erneuten Aufbauen des Druckpolsters innerhalb der Druckkammer wird das Rückschlagventil wieder geschlossen.

Es ist zwar aus der gattungsfremden DE 15 27 412 vorbekannt, innerhalb eines druckdichten Lotbadbehälters, an den ein Lotförderungsschacht anschliesst, einen glockenartig umschlossenen Verdrängungsraum anzuordnen, an welchem eine Druckluftzuführung angeschlossen ist. Mittels der Druckluftzuführung kann aus dem Verdrängungsraum flüssiges Lot verdrängt werden, welches das im druckdichten Lotbadbehälter befindliche Lot im Lotschacht nach aufwärts drückt, bis das Lot in den Bereich der lötbereiten Lage am freien Ende des Schachtes aufgestiegen ist. Hier kann mittels besonderer Fördereinrichtungen ein Tauchlöten durchgeführt werden, in dem mittels einer speziellen mechanischen Einrichtung die Bauteilbeinchen von an Leiterplatten zu verlötenden elektronischen Bauteilen in das Lot am freien Ende des Schachtes eingetaucht und wieder herausgehoben werden. Ein Schwallötverfahren gemäss der Erfindung, bei welchem das Lot ständig aus der Schwallerzeugungsdüse austritt und der Druckkammer wieder zugeführt wird, ist hiermit nicht möglich.

Weitere vorteilhafte Ausgestaltungen der Erfindung ergeben sich aus den Unteransprüchen, wobei insbesondere auf die kompakte Bauweise des erfindungsgemässen Schwallötgerätes hingewiesen wird.

Die Erfindung ist nachfolgend anhand eines in den Zeichnungen dargestellten Ausführungsbeispieles eines Schwallötgerätes näher erläutert. Es zeigen:

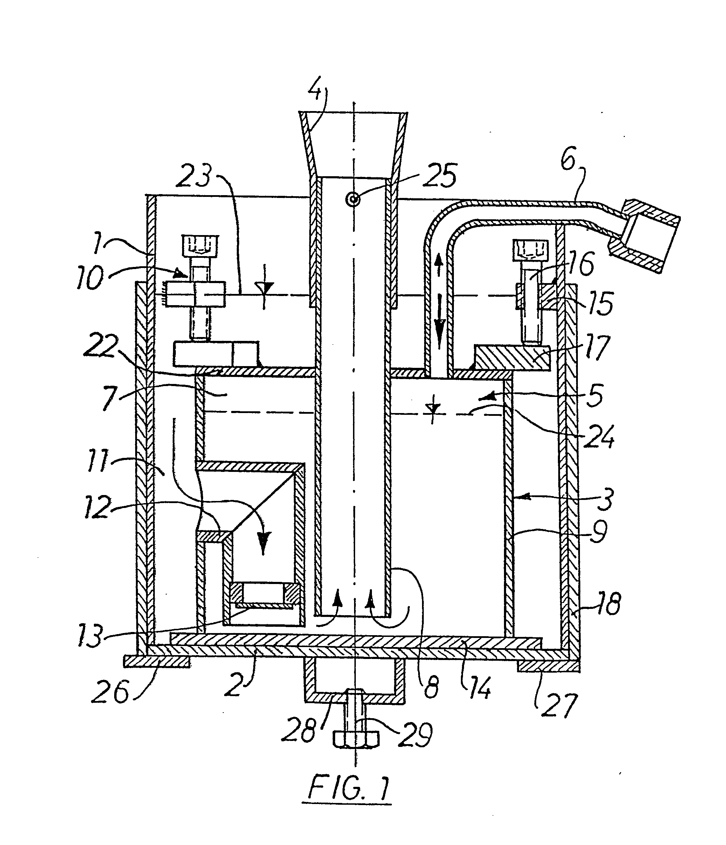

Fig. 1 einen Vertikalschnitt durch das Schwallötgerät gemäss der Linie I-I in Fig. 2,

Fig. 2 eine Draufsicht auf das Schwallötgerät und

Fig. 3 eine Seitenansicht.

Das Schwallötgerät kann sowohl zum Löten als auch zum Entlöten von elektronischen Bauteilen an Leiterplatten dienen, wozu es auf der Unterseite von Hand oder automatisch über eine Förderstrasse zugeführten Leiterplatten angeordnet wird.

Das Schwallötgerät umfasst innerhalb eines zylindrischen Lötbadbehälters 1 mit kreisscheibenförmigen Boden 2 eine Druckkammer 3 aus einem zylindrischen, durch eine Deckwand 22 auf der Oberseite verschlossenen Hohlkörper 9, der nach unten offen ist und mittels einer Dichtscheibe 14 aus rostfreiem Stahl am Boden 2 des Lötbadbehälters 1 abgedichtet ist. Als Druckelemente 10 zum Aufbringen des Abdichtungsdruckes dienen Druckschrauben 16, die in an der Innenwand des Lötbadbehälters angeschweissten Lagerbüchsen 15 schraubbar sind und die gegen Gegenlager 17 drücken, welche auf der Deckwand 22 der Druckkammer 3 angeschweisst sind und diese allseitig überragen.

Der Querschnitt des Hohlkörpers 9 ist geringer als der Querschnitt des Lötbadbehälters 1, so dass zwischen beiden ein kreisringförmiger Zwischenraum als Rücklaufkammer 11 für flüssiges Lot gebildet ist.

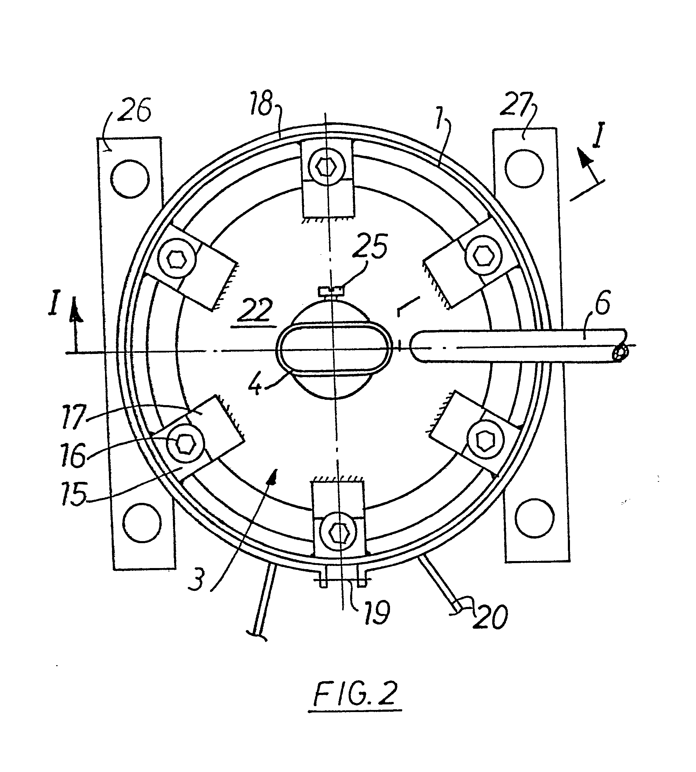

In die Druckkammer 3 ragt konzentrisch zum zylindrischen Hohlkörper 9 ein Hohlschaft 8, der mit seinem unteren Ende nahe der auf den Boden 2 des Lötbadbehälters 1 aufgepressten Dichtscheibe 14 angeordnet ist und auf dessen oberem Ende die Schwallerzeugungsdüse 4 mittels einer Klemmschraube 25 befestigt ist. Die Schwallötdüse 4 hat einen länglich-ovalen Querschnitt, wie es in Fig. 2 in der Draufsicht dargestellt ist.

In die Deckwand 22 der Druckkammer 3 mündet eine Druckluftleitung 6, die mit einer nicht dargestellten Druckluftquelle über ein ebenfalls nicht dargestelltes Drei-Wege-Ventil verbunden ist.

Die kreisringförmige Rücklaufkammer 11 ist mit der Druckkammer 3 über eine Rücklaufleitung 12 in Form eines nach unten abgewinkelten Rohres verbunden, an dessen unterem Ausgang ein Rückschlagventil 13 in Form eines Klappenventils angeordnet ist, das unter Wirkung eines in der Druckkammer 3 herrschenden Überdruckes selbsttätig schliesst.

Der Lötbadbehälter 1 ist aussen von einer Heizmanschette 18 umgeben, die mittels Klemmelementen 19 am Lötbadbehälter 1 befestigt ist und mit elektrischen Zuleitungen 20 verbunden ist.

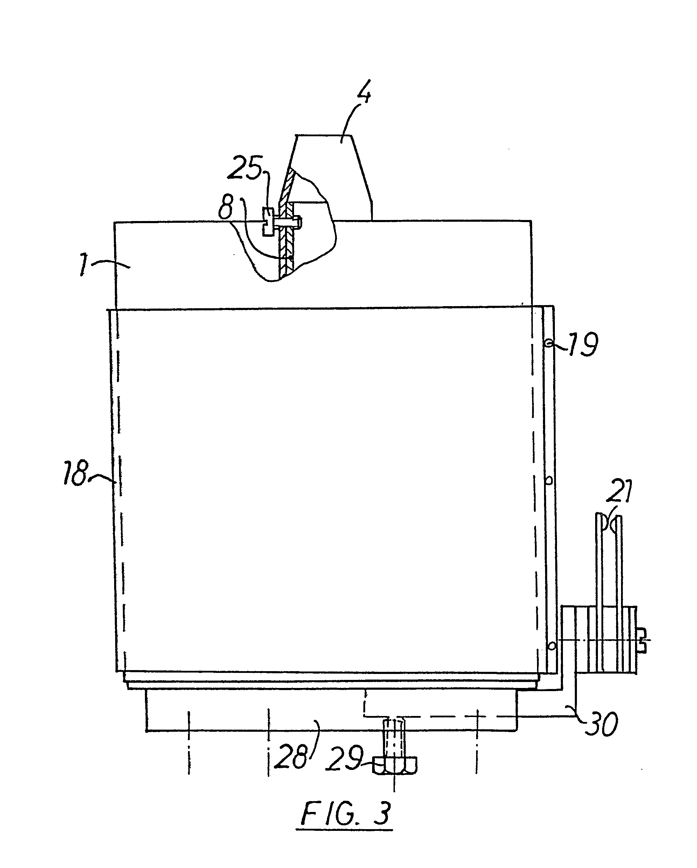

Der Lötbadbehälter 1 weist zwei unterhalb seines Bodens 2 befestigte Standfüsse 26, 27 auf. Ferner ist unterhalb des Bodens 2 eine U-förmige Schiene 28 mit Klemmschrauben 29 vorgesehen, die zum Einklemmen von Winkelstücken 30 zur Anordnung von die Heizung 18 steuernden Bimetallelementen 21 dient (Fig. 3).

Nachstehend wird die Funktion des voranstehend beschriebenen Schwallötgerätes erläutert:

Zur Erzeugung einer Lötwelle zum Löten oder Entlöten wird mittels der Heizmanschette 18 das innerhalb des Lötbadbehälters 1 befindliche Lot verflüssigt, das etwa das Lotniveau 23 einnimmt. Unter Wirkung von durch die Druckluftleitung 6 zugeführter Druckluft (grosser schwarzer Pfeil) wird in der Druckerzeugungseinrichtung 5 unmittelbar unterhalb der Deckwand 22 der Druckkammer 3 ein Druckluftpolster 7 gebildet, so dass das Lotniveau 24 innerhalb der Druckkammer 3 entsteht, wobei das aus der Druckkammer 3 verdrängte flüssige Lot durch den Hohlschaft 8 (Pfeile am unteren Eintritt des Hohlschaftes 8) aufsteigt und aus der Schwallerzeugungsdüse 4 als Lötwelle austritt. Dabei ist das Rückschlagventil 13 unter Wirkung des in der Druckkammer 3 auftretenden Druckes geschlossen, der grösser ist als der innerhalb der Rücklaufkammer 11 erzeugte Gegendruck. Bei weiterer Zufuhr von Druckluft kann das Lotniveau 24 durch Vergrösserung des Druckluftpolsters 7 weiterhin abgesenkt werden, bis kurz bevor dieses die untere Einmündung des Hohlschaftes 8 erreicht. Solange kann eine aus der Düse 4 austretende Lötwelle aufrechterhalten werden. Nach Unterbrechung der Zufuhr von Druckluft und Umsteuern des nicht dargestellten, in der Druckluftleitung angeordneten Dre-Wege-Ventiles wird das Druckluftpolster 7 wieder abgebaut (kleiner Pfeil in der Druckluftleitung 6), wobei das aus der Düse 4 ausgetretene, in die Rücklaufkammer 11 eingetretene flüssige Lot durch das dann geöffnete Rückschlagventil 13 in die Druckkammer 3 einströmen kann. Ein erneuter Arbeitszyklus kann beginnen. Das beschriebene Schwallötgerät lässt sich insbesondere für die intervallartige Erzeugung von Lötwellen verwenden, wobei regelmässig ruhige und konstante Lötwellen über einen bestimmten Zeitraum aufrechterhalten werden können.

Das Schwallötgerät lässt sich leicht reinigen, in dem die Druckschrauben 16 gelöst und die Druckkammer 3 um etwa 30° um ihre Achse gedreht wird, woraufhin die Druckkammer 3 aus dem Lötbadbehälter 1 entnommen werden kann, wobei die Gegenlager 17 jeweils mittig zwischen den Lagerbüchsen 15 herausgeführt werden können.

Sämtliche Bauteile des Schwallötgerätes bestehen aus gegen heisses, flüssiges Lot beständigem Material, insbesondere rostfreiem Stahl.

## Patentansprüche

1. Schwallötgerät zum Löten und Entlöten, insbesondere von elektronischen Bauteilen an Leiterplatten, aus einem flüssiges Lot aufnehmenden, beheizten Lotbadbehälter (1) mit einer eine Deckwand (22) und einen Boden (2) aufweisenden Druckkammer (3), einer Rücklaufkammer (11) und einer an diese anschliessenden, vertikal nach oben gerichteten Schwallerzeugungsdüse (4) und aus einer Druckerzeugungseinrichtung (5) zur Förderung des Lotes aus der Druckkammer in die Schwallerzeugungsdüse, dadurch gekennzeichnet, dass als Druckerzeugungseinrichtung (5) ein über eine in der Deckwand (22) der Druckkammer (3) mündende Druckluftleitung (6) von einer Druckluftquelle gespeistes, unterhalb der Deckwand (22) der Druckkammer (3) gebildetes Druckluftpolster (7) vorgesehen ist, dass die Schwallerzeugungsdüse (4) mit einem in die Druckkammer (3) ragenden, bis dicht an den Boden (2) der Druckkammer (3) geführten Hohlschaft (8) versehen ist, dass die Druckkammer (3) in den oben offenen Lotbadbehälter (1) mit Abstand eingesetzt ist, wobei der Zwischenraum zwischen der Druckkammer (3) und dem Lotbadbehälter (1) die Rücklaufkammer (11) für das aus der Düse (4) austretende flüssige Lot bildet, und dass die Rücklaufkammer (11) mit dem die Druckkammer (3) bildenden Hohlkörper (9) über eine Rücklaufleitung (12) verbunden ist, in die ein Rückschlagventil (13) eingesetzt ist.

2. Schwallötgerät nach Anspruch 1, dadurch gekennzeichnet, dass die Druckkammer aus einem unten offenen Hohlkörper (9) gebildet ist, der durch Druckelemente (10) dichtend auf den Boden (2) des Lotbadbehälters (1) gedrückt ist.

3. Schwallötgerät nach Anspruch 2, dadurch gekennzeichnet, dass am Boden (2) des Lotbadbehälters (1) eine Dichtscheibe (14) für den Hohlkörper (9) angeordnet ist.

4. Schwallötgerät nach einem der Ansprüche 2 oder 3, dadurch gekennzeichnet, dass als Druckelemente (10) an der inneren Wand des Lotbadbehälters (1) in Lagerböcken (15) schraubbare Druckschrauben (16) vorgesehen sind, die an über den Umfang der Druckkammer (3) hinausragenden, an deren Oberwand (22) aussen angeschweisste Gegenlager (17) an der Druckkammer (3) angreifen.

5. Schwallötgerät nach einem der Ansprüche 1 oder 4, dadurch gekennzeichnet, dass die Rücklaufleitung (12) in Form eines nach unten abgewinkelten Rohres ausgebildet ist, an dessen unterem Ausgang das Rückschlagventil (13) in Form eines Klappenventiles angeordnet ist, das unter Wirkung eines in der Druckkammer (3) herrschenden Überdruckes selbsttätig schliesst.

6. Schwallötgerät nach einem der vorangegangenen Ansprüche, dadurch gekennzeichnet, dass in der Druckluftleitung (6) zwischen der Druckluftquelle und der Druckkammer (3) ein Drei-Wege-Ventil zur Entlüftung des Druckpolsters (7) vorgesehen ist.

## Claims

1. Wave soldering device for soldering in and out particularly of electronic components on printed-circuit boards, consisting of a heated soldering-bath container (1) accommodating a liquid solder, a pressure chamber (3) provided with a cover wall (22) and a bottom (2), a return chamber (11), and a wave-generating nozzle (4) connectable to said return chamber (11) and being directed vertically upward and a pressure-generating device (5) for transporting the solder from the pressure chamber into the wave-generating nozzle, characterized by that as pressure-generating device (5) a pressurized-air cushion (7) is provided, said cushion being formed by a pressurized-air line (6) guided into the cover wall (22) of the pressure chamber (3) and being supplied from a pressurized-air source and being arranged underneath the cover wall (22) of the pressure chamber (3), that the wave-generating nozzle (4) is provided with a hollow shaft (8) protruding into the pressure chamber (3) and being guided closely up to the bottom (2) of the pressure chamber (3), that the pressure chamber (3) is inserted into the soldering-bath container (1) being open towards top, whereby the space between the pressure chamber (3) and the soldering-bath container (1) forms the return chamber (11) for the liquid solder emerging from the nozzle (4), and that the return chamber (11) is connected over a return line (12) to the hollow body (9) forming the pressure chamber (3), a check valve (13) being integrated in said line (12).

2. Wave soldering device according to claim 1, characterized by that the pressure chamber is formed by a hollow body (9) being open towards bottom, this body being pressed by pressure elements (10) in a sealing manner on the bottom (2) of the soldering-bath container (1).

3. Wave soldering device according to claim 2, characterized by that a sealing disk (14) for the hollow body (9) is arranged on the bottom (2) of the soldering-bath container (1).

4. Wave soldering device according to one of claims 2 or 3, characterized by that the pressure elements (10) on the interior wall of the soldering-bath container (1) are designed as pressing screws (16) to be screwed into bearing blocks (15), said screws acting on counterbearings (17) protruding over the periphery of the pressure chamber (3) and being welded on the outside on its upper wall (22).

5. Wave soldering device according to one of claims 1 or 4, characterized by that the return line (12) is designed as a pipe being angled towards bottom, at the outlet of said pipe the check valve (13) being arranged in the form of a flap valve closing automatically due to the action of an overpressure in the pressure chamber (3).

6. Wave soldering device according to one of the preceding claims, characterized by that in the pressurized-air line (6) between the source of pressurized air and the pressure chamber, a three-way valve is provided for pressure release of the pressure cushion (7).

## Revendications

1. Dispositif de brasage tendre à la vague pour le brasage et le désoudage, surtout de composants électroniques sur des plaquettes à circuit imprimé, comprenant un récipient du bain de brasage (1) chauffé recueillant le métal d'apport de brasage liquide, une chambre de compression (3) avec une paroi de recouvrement (22) et un fond (2), une chambre de reflux (11), une buse de génération de vague (4) dirigée verticalement vers le haut et montée en aval de la chambre de reflux, et un dispositif de production de pression (5) pour le transport du métal d'apport de la chambre de compression vers la buse de génération de la vague, caractérisé par le fait qu'un matelas d'air comprimé (7) formé sous la paroi de recouvrement (22) de la chambre de compression (3) est alimenté par une source d'air comprimé à travers une canalisation (6) aboutissant dans la paroi de recouvrement (22) de la chambre de compression (3), que la buse de génération de la vague (4) est munie d'une tige creuse (8) faisant saillie dans la chambre de compression (3) et allant jusqu'à tout près du fond (2) de la chambre de compression (3), que la chambre de compression (3) est incorporée dans le récipient du bain de brasage (1) ouvert, se trouvant à une certaine distance, cet espace intermédiaire entre la chambre de compression (3) et le récipient du bain de brasage (1) formant la chambre de reflux (11) pour le métal d'apport liquide sortant de la buse (4), et que la chambre de reflux (11) est reliée à travers une canalisation de reflux (12) avec le corps creux (9) formant la chambre de compression (3), un clapet de non-retour étant incorporé dans la canalisation (12).

2. Dispositif de brasage tendre à la vague selon la revendication 1, caractérisé par le fait que la chambre de compression est formée par un corps creux (9) ouvert sur le dessous, serré par des éléments de pression (10) de façon étanche sur le fond (2) du récipient du bain de brasage (1).

3. Dispositif de brasage tendre à la vague selon la revendication 2, caractérisé par le fait qu'un disque d'étanchéité (14) pour le corps creux (9) est disposé sur le fond (2) du récipient du bain de brasage (1).

4. Dispositif de brasage tendre à la vague selon l'une des revendications 2 ou 3, caractérisé par le fait que des vis de serrage (16) vissables dans des butées (15) sont prévues comme éléments de serrage (10) sur la paroi intérieure du récipient du bain de brasage (1). Ces vis (16) mordent sur des butées (17) soudées à l'extérieur de la paroi supérieure (22) de la chambre de compression (3).

5. Dispositif de brasage tendre à la vague selon l'une des revendications 1 ou 4, caractérisé par le fait que la canalisation de reflux (12) est conçue en forme d'un tube coudé, à la sortie inférieure duquel est disposé un clapet de non-retour (13) sous forme de papillon fermant automatiquement sous l'effet d'une surpression régnant dans la chambre de compression (3).

6. Dispositif de brasage tendre à la vague selon les revendications ci-dessus, caractérisé par le fait qu'un distributeur à trois voies pour l'aération du matelas d'air comprimé (7) est prévu dans la canalisation d'air comprimé (6) entre la source d'air comprimé et la chambre de compression (3).

FIG. 1

FIG.2

FIG. 3